# EUROPÄISCHE PATENTSCHRIFT

(11) **EP 1 714 309 B1**
(45) Veröffentlichungstag und Bekanntmachung des Hinweises auf die Patenterteilung: **13.06.2007**
(21) Anmeldenummer: 05716666.2
(22) Anmeldetag: 11.02.2005
(51) Int. Cl.: H01L 21/00

(54) **EINRICHTUNG ZUM AUFBRINGEN EINER FLÜSSIGEN DOTIERUNGSSTOFFLÖSUNG AUF EINEM WAFER**
DEVICE FOR APPLYING A LIQUID DOPANT SOLUTION ON A WAFER
DISPOSITIF D'APPLICATION D'UNE SOLUTION LIQUIDE DE DOPANT SUR UNE PLAQUETTE

(30) Priorität: 13.02.2004 EP 04003270
(43) Veröffentlichungstag der Anmeldung: 25.10.2006
(73) Patentinhaber: Shell Solar GmbH, 81739 München (DE)
(72) Erfinder: MÜNZER, Adolf, D-85717 Unterschleissheim (DE)
(74) Vertreter: Rau, Albrecht
(86) Internationale Anmeldenummer: PCT/EP2005/050611
(87) Internationale Veröffentlichungsnummer: WO 2005/081286

(56) Entgegenhaltungen:
- EP-A- 0 140 165
- WO-A-93/09950
- WO-A-02/061854
- WO-A-02/088243
- US-A- 5 972 784

## Beschreibung

Die vorliegende Erfindung bezieht sich auf das Aufbringen einer flüssigen Dotierlösung auf die Oberfläche eines Wafers. Ein solcher Wafer ist zweckmäßigerweise ein bei der Herstellung eines Photoelements verwendeter Siliciumwafer.

Wenn ein Wafer bei der Herstellung eines Photoelements verwendet wird, wird dieser mit einer Volumendotierung versehen. Eine der beiden Oberflächen des Wafers wird als Beleuchtungsfläche bezeichnet, und die Seite des Wafers ist die Beleuchtungsseite. An seiner Beleuchtungsseite ist der Wafer mit einer dünnen Schicht versehen, die eine Dotierung aufweist, welche sich von der Volumendotierung unterscheidet. Der Wechsel zwischen der Volumen- und der Dünnschichtregion wird Übergang genannt.

Es gibt einen Trend, eine Dotierung auch auf der Rückseite des Wafers aufzubringen (der Seite des Wafers, die der Beleuchtungsseite entgegengesetzt ist). Dies wird gemacht, um ein sogenanntes Back Surface Field zu erzeugen, welches ein auf der Rückseite eingebautes elektrisches Feld ist, das Minoritätsladungsträger ablenkt und die Rekombinationsrate an der rückseitigen Oberfläche verringert. Eine dotierte Dünnschicht an der Beleuchtungsseite des Wafers oder an seiner Rückseite kann auf drei Wegen erhalten werden: (1) Abscheiden des Dotierungsmittels in gasförmigem Zustand bei erhöhter Temperatur, so dass das gasförmige Dotierungsmittel in den Wafer diffundieren kann, (2) Aufbringen einer ein Dotierungsmittel enthaltenden Paste auf die Oberfläche des Wafers und Erwärmen des Wafers, damit das Dotierungsmittel in den Wafer diffundieren kann, und (3) Aufbringen einer flüssigen Dotierlösung auf die Oberfläche des Wafers mit der darauf befindlichen Dotierlösung, um das Lösungsmittel zu verdampfen und das Dotierungsmittel zu veranlassen, in den Wafer zu diffundieren.

Das Aufbringen einer flüssigen Dotierlösung kann mit unterschiedlichen Techniken erfolgen, die in der Beschreibung des USA-Patents Nr. 5,972,784 besprochen werden. Eine Technik besteht im Aufsprühen der flüssigen Dotierlösung auf die Oberfläche eines Wafers, eine andere Technik besteht im Auftropfenlassen eines kleinen Volumens einer flüssigen Dotierlösung auf die Oberfläche eines sich drehenden Wafers, so dass sich die flüssige Dotierlösung gleichmäßig über der Oberfläche ausbreiten kann, und eine dritte Technik besteht im Eintauchen des Wafers in eine Dotierlösung.

Die vorliegende Erfindung betrifft ebenfalls das Aufbringen einer flüssigen Dotierlösung auf die Oberfläche eines Wafers.

Die Produktionsrate, was die Anzahl von Wafern ist, die mit der Dotierlösung versehen werden kann, ist bei den bekannten Techniken niedrig. Um die Kosten der Solarenergie zu reduzieren, ist eine höhere Produktionsrate erforderlich.

Es ist eine Aufgabe der vorliegenden Erfindung, eine Vorrichtung zum Aufbringen einer flüssigen Dotierlösung auf die Oberfläche eines Wafers zu schaffen, die eine hohe Produktionsrate zulässt.

Zu diesem Zweck umfasst die Vorrichtung zum Aufbringen einer flüssigen Dotierlösung auf die Oberfläche eines Wafers eine Dotiermittel-Verteileinrichtung, eine drehbare Dotiermittel-Übertragungsrolle, die in einer Richtung senkrecht zur Drehachse der Dotiermittel-Übertragungsrolle zwischen einer ersten Rollenposition und einer zweiten Rollenposition horizontal verschiebbar ist, und einen Arbeitstisch zum Halten des mit der Dotierlösung zu versehenen Wafers während des normalen Betriebs, wobei die Dotiermittel-Verteileinrichtung einen durch einen Blockhalter abgestützten Dotiermittel-Übertragungsblock und einen Fluidbehälter mit einer durch einen Rand umschlossenen offenen Seite, wobei die offene Seite dem Dotiermittel-Übertragungsblock zugewandt ist und der Rand mit dem Dotiermittel-Übertragungsblock, dem Blockhalter oder beiden zusammenwirkt, um eine Entweichen der Dotierlösung zu verhindern, wobei der Blockhalter und der Fluidbehälter relativ zueinander verschoben werden können, wobei der Blockhalter horizontal verschiebbar ist in einer Richtung senkrecht zur Drehachse der Dotiermittel-Übertragungsrolle zwischen einer ersten Blockposition, in welcher sich der Dotiermittel-Übertragungsblock unter der offenen Seite des Fluidbehälters befindet, und einer zweiten Blockposition, in welcher der Dotiermittel-Übertragungsblock mit der drehbaren Dotiermittel-Übertragungsrolle in ihrer ersten Rollenposition in Berührung gekommen ist, wobei die drehbare Dotiermittel-Übertragungsrolle während des normalen Betriebs in der zweiten Rollenposition mit dem Wafer in Kontakt gekommen ist, um Dotierlösung auf die Oberfläche des Wafers zu bringen.

Zur Vollständigkeit wird Bezug genommen auf die Beschreibung des USA-Patents Nr. 4,557,195. Diese Veröffentlichung bezieht sich auf eine Vorrichtung zum Bedrucken eines Gegenstandes, wobei die Vorrichtung eine Einrichtung zum Versehen eines Druckstocks mit Farbe umfasst. Die bekannte Vorrichtung umfasst eine Farbverteilungseinrichtung mit einem Druckstock, der durch einen Druckstockhalter abgestützt wird, und einem Farbbehälter mit einer durch einen Rand umschlossenen offenen Seite, wobei die offene Seite dem Druckstock zugewandt ist und wobei der Rand mit dem Druckstock und dem Druckstockhalter zusammenwirkt, um ein Auslaufen der Farbe zu verhindern, wobei der Druckstockhalter und der Farbbehälter relativ zueinander verschoben werden können, wobei der Druckstockhalter horizontal verschiebbar ist zwischen der ersten Druckstockposition, in welcher sich der Druckstock unter der offenen Seite des Farbbehälters befindet, und einer frei liegenden Position, in welcher der Druckstock frei vom Fluidbehälter liegt.

Während des normalen Betriebs wird der Druckstock (auch Klischee genannt), welcher geprägt ist, stationär gehalten und der Farbbehälter von der ersten Position, in welcher der Druckstock mit Farbe versehen wird, zu der frei liegenden Position verschoben. In der frei liegenden Position wird ein Gummikissen auf den Druckstock gepresst, so dass dieses die Farbe vom Druckstock annimmt. Nach Annahme der Farbe wird das Kissen weg gedreht, um einen Gegenstand zu bedrucken.

Eine Alternative zu der obigen Vorrichtung ist offenbart in der internationalen Patentanmeldung Veröffentlichungsnummer 93/09950. Die in dieser Veröffentlichung offenbarte Vorrichtung unterscheidet sich von der oben beschriebenen Vorrichtung zum Einfärben eines Druckstocks darin, dass während des normalen Betriebs der Druckstock stationär gehalten wird und der Farbbehälter relativ zum Druckstock verschoben wird.

Es wird ferner Bezug genommen auf die internationale Patentanmeldung Veröffentlichungsnummer 02/08243. Diese Veröffentlichung bezieht sich auf das Aufbringen einer dünnen Schicht auf ein Substrat mit Hilfe eines Siebdruckverfahrens unter Verwendung eines Siebes in Form eines kontinuierlichen Bandes.

Ferner wird Bezug genommen auf die internationale Patentanmeldung Veröffentlichungsnummer 02/061854. Diese Veröffentlichung bezieht sich auf ein Verfahren zum Strukturieren einer auf ein Substrat aufgebrachten Oxidschicht, wobei dem Siebdruckverfahren entsprechend eine Paste auf die Oxidschicht aufgebracht wird, die eine Komponente zum Ätzen eines Oxids enthält, und wobei die gedruckte Paste entfernt wird, nachdem sie für eine vorbestimmte Zeit auf die Oxidschicht eingewirkt hat.

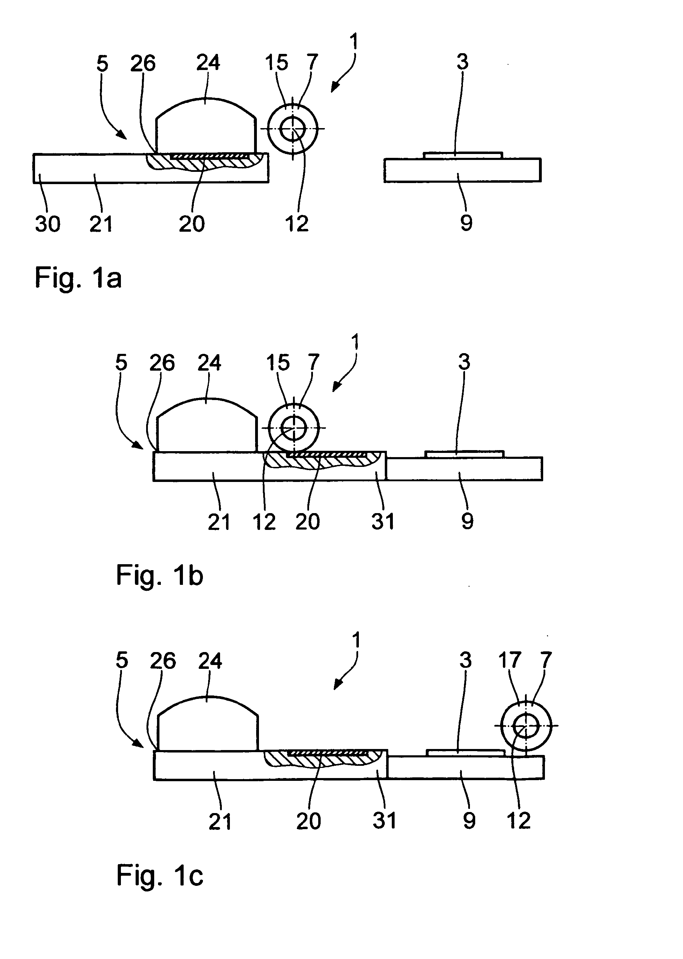

Die Erfindung wird nun beispielhaft in weiteren Einzelheiten mit Bezug auf die beigefügten Zeichnungen besprochen, wobei die Figuren 1a, 1b und 1c schematisch und nicht maßstabgerecht sie Vorrichtung zum Auftragen eines flüssigen Dotiermittels gemäß der vorliegenden Erfindung in drei unterschiedlichen Betriebspositionen zeigen.

Die Vorrichtung 1 zum Aufbringen einer flüssigen Dotierlösung auf die Oberfläche eines Wafers 3 umfasst eine Dotiermittel-Verteileinrichtung 5, eine drehbare Dotiermittel-Übertragungsrolle 7 und einen Arbeitstisch 9 zum Halten des mit der Dotierlösung zu versehenden Wafers 3 während des normalen Betriebs.

Die drehbare Dotiermittel-Übertragungsrolle 7 ist in einer Richtung senkrecht zur Drehachse 12 der Dotiermittel-Übertragungsrolle 7 zwischen einer ersten Rollenposition 15 und einer zweiten Rollenposition 17 horizontal verschiebbar. Es sei bitte darauf hingewiesen, dass sich die Achse 12 senkrecht zur Zeichnungsebene erstreckt.

Die Verteileinrichtung 5 umfasst einen Dotiermittel-Übertragungsblock 20, der durch einen Blockhalter 21 abgestützt wird, und einen Fluidbehälter 24 mit einer offenen Unterseite, die durch einen Dichtungsrand 26 eingefasst ist. Die offene Seite ist dem Dotiermittel-Übertragungsblock 20 zugewandt. Der Dichtungsrand 26 wirkt mit dem Dotiermittel-Übertragungsblock 20, dem Blockhalter 21 oder sowohl mit dem Dotiermittel-Übertragungsblock 20 als auch mit dem Blockhalter 21 zusammen, um ein Austreten der Dotierlösung zu verhindern.

Der den Dotiermittel-Übertragungsblock 20 abstützende Blockhalter 21 und der Fluidbehälter 24 können relativ zueinander verschoben werden. Der Blockhalter 21 ist in einer Richtung senkrecht zur Drehachse 12 der Dotiermittel-Übertragungsrolle 7 horizontal verschiebbar, und zwar zwischen einer ersten Blockposition 30, in welcher sich der Dotiermittel-Übertragungsblock 20 unter der offenen Seite des Fluidbehälters 24 befindet, und einer zweiten Blockposition 31, in welcher der Dotiermittel-Übertragungsblock 20 mit der drehbaren Dotiermittel-Übertragungsrolle 7 in ihrer ersten Rollenposition 15 in Kontakt gelangt ist.

Die zweite Rollenposition 17 der drehbaren Dotiermittel-Übertragungsrolle 7 ist so gewählt, dass die Dotiermittel-Überiragungsrolle 7 in der zweiten Rollenposition 17 mit dem Wafer 3 in Kontakt gelangt ist, um Dotierlösung auf die Oberfläche des Wafers 3 zu bringen.

Einrichtungen zum Abstützen und Führen des Blockhalters 21 und der Dotiermittel-Übertragungsrolle 7 und Einrichtungen zum Abstützen des Arbeitstisches 9 sind in den Figuren nicht dargestellt.

Während des normalen Betriebs ist ein mit einer Dotierlösung zu versehender Wafer 3 auf dem Arbeitstisch 9 sicher festgelegt. Der Fluidbehälter 24 ist mit Dotierlösung gefüllt. Der Blockhalter 21 befindet sich in seiner ersten Blockposition 30 und die Dotiermittel-Übertragungsrolle 7 befindet sich in ihrer ersten Position 15. In seiner ersten Position befindet sich der Block 20 unter der offenen Seite des Fluidbehälters, und die Dotierlösung kann den Dotiermittel-Übertragungsblock 20 benässen. Diese Ausgangsposition ist in Figur 1a dargestellt.

Dann kehren die Dotiermittel-Übertragungsrolle 7 und der Blockhalter 21 in ihre jeweiligen ersten Positionen zurück, wie in Figur 1a gezeigt, wobei der mit der Dotierlösung versehene Wafer 3 entnommen wird und ein neuer Wafer in den Arbeitstisch gesetzt wird.

Es ist klar, dass die Anfangsposition, wie sie in Fig. 1a gezeigt ist, auch erreicht werden kann, indem der Blockhalter 21 gleichzeitig mit dem Verschieben der Dotiermittel-Übertragungsrolle 7 in die zweite Rollenposition 17 in die erste Blockposition 30 zurück gebracht wird, und danach die Dotiermittel-Übertragungsrolle 7 in die erste Rollenposition 15 zurück gebracht wird.

Zweckmäßigerweise ist der Dotiermittel-Übertragungsblock 20 aus Kunststoff, Stahl oder einem Keramikmaterial hergestellt und ist mit einer geeigneten Struktur versehen. Die Dotiermittel-Übertragungsrolle 7 ist zweckmäßigerweise aus einem Silicongummi hergestellt.

Die Oberfläche des Wafers, auf welchem die Dotierlösung aufgebracht wird, kann eine flache Oberfläche oder eine strukturierte Oberfläche sein.

Die Vorrichtung gemäß der vorliegenden Erfindung erlaubt eine Dotierung von etwa 1000 Wafern pro Stunde. Zudem erlaubt die vorliegende Erfindung das Aufbringen einer dünnen gleichmäßigen Schicht der Dotierlösung, wobei die Dicke der Schicht der Dotierlösung zwischen 1 und 10 Mikrometer beträgt. Die Schicht kann über einen großen Oberflächenbereich (mehr als 100 cm²) und auf dünne Wafer (weniger als etwa 100 Mikrometer) aufgebracht werden.

## Patentansprüche

1. Vorrichtung (1) zum Aufbringen einer flüssigen Dotierlösung auf die Oberfläche eines Wafers (3), wobei die Vorrichtung (1) umfasst eine Dotiermittel-Verteileinrichtung (5), eine drehbare Dotiermittel-Übertragungsrolle (7), die in einer Richtung senkrecht zur Drehachse (12) der Dotiermittel-Übertragungsrolle (7) zwischen einer ersten Rollenposition (15) und einer zweiten Rollenposition (17) horizontal verschiebbar ist, und einen Arbeitstisch (9) zum Halten des mit der Dotierlösung zu versehenden Wafers (3) während des normalen Betriebs, wobei die Dotiermittel-Verteileinrichtung (5) aufweist einen Dotiermittel-Übertragungsblock (20), der durch einen Blockhalter (21) abgestützt ist, und einen Fluidbehälter (24) mit einer durch einen Rand (26) eingefassten offenen Seite, wobei die offene Seite dem Dotiermittel-Übertragungsblock (20) zugewandt ist und wobei der Rand (26) mit dem Dotiermittel-Übertragungsblock (20), dem Blockhalter (21) oder beiden zusammenwirkt, um ein Austreten der Dotierlösung zu verhindern, wobei der Blockhalter (21) und der Fluidbehälter (24) relativ zueinander verschoben werden können, wobei der Blockhalter (21) horizontal verschiebbar ist in einer Richtung senkrecht zur Drehachse (12) der Dotiermittel-Übertragungsrolle (7) zwischen einer ersten Blockposition (30), in welcher sich der Dotiermittel-Übertragungsblock (20) unter der offenen Seite des Fluidbehälters (24) befindet, und einer zweiten Blockposition (31), in welcher der Dotiermittel-Übertragungsblock (20) mit der drehbaren Dotiermittel-Übertragungsrolle (7) in ihrer ersten Rollenposition (15) in Kontakt gelangt ist, wobei die drehbare Dotiermittel-Übertragungsrolle (7) während des normalen Betriebs in der zweiten Rollenposition (17) mit dem Wafer (3) in Kontakt gelangt ist, um Dotierlösung auf die Oberfläche des Wafers (3) zu bringen.

## Claims

1. A device (1) for applying a liquid dopant solution on the surface of a wafer (3), which device (1) comprises a dopant distribution device (5), a rotatable dopant-transfer roll (7) horizontally translatable in a direction perpendicular to the axis of rotation (12) of the dopant-transfer roll (7) between a first roll position (15) and a second roll position (17), and a work table (9) for holding during normal operation the wafer (3) to be provided with the dopant solution, wherein the dopant distribution device (5) comprises a dopant-transfer block (20) supported by a block holder (21) and a fluid container (24) having an open side enclosed by an edge (26), which open side is directed to the dopant-transfer block (20) and which edge (26) cooperates with the dopant-transfer block (20), the block holder (21) or both to prevent leaking of dopant solution, wherein the block holder (21) and the fluid container (24) can be displaced relative to each other, wherein the block holder (21) is horizontally translatable in a direction perpendicular to the axis of rotation (12) of the dopant-transfer roll (7) between a first block position (30) in which the dopant-transfer block (20) is under the open side of the fluid container (24) and a second block position (31) in which the dopant-transfer block (20) has contacted the rotatable dopant-transfer roll (7) in its first roll position (15), wherein during normal operation in the second roll position (17) the rotatable dopant-transfer roll (7) has contacted the wafer (3) to provide dopant solution onto the surface of the wafer (3).

## Revendications

1. Dispositif (1) destiné à l'application d'une solution liquide dopante sur la surface d'une tranche (3), le dispositif (1) comportant un système de répartition (5) d'agent dopant, un rouleau de transfert rotatif (7) d'agent dopant, qui peut être déplacé horizontalement dans une direction perpendiculaire à l'axe de rotation (12) du rouleau de transfert (7) d'agent dopant entre une première position (15) de rouleau et une deuxième position (17) de rouleau, et une table de travail (9) pour le maintien pendant le fonctionnement normal de la tranche (3) devant être pourvue de la solution dopante, le système de répartition (5) d'agent dopant comportant un bloc de transfert (20) d'agent dopant, qui est supporté par un porte-bloc (21), et un récipient de fluide (24) avec un coté ouvert entouré d'un bord (26), le côté ouvert étant orienté vers le bloc de transfert (20) d'agent dopant, et le bord (26) agissant conjointement avec le bloc de transfert (20) d'agent dopant, le porte-bloc (21) ou les deux, afin d'empêcher un écoulement de la solution dopante, le porte-bloc (21) et le récipient de fluide (24) pouvant être déplacés l'un par rapport à l'autre, le porte-bloc (21) pouvant être déplacé horizontalement dans une direction perpendiculaire à l'axe de rotation (12) du rouleau de transfert (7) d'agent dopant, entre une première position (30) de bloc dans laquelle le bloc de transfert (20) d'agent dopant est situé sous le côté ouvert du récipient de fluide (24), et une deuxième position (31) de bloc dans laquelle le bloc de transfert (20) d'agent dopant arrive en contact avec le rouleau de transfert rotatif (7) d'agent dopant dans sa première position (15) de rouleau, étant précisé que, pendant le fonctionnement normal, le rouleau de transfert rotatif (7) d'agent dopant arrive en contact avec la tranche (3) dans la deuxième position (17) de rouleau, afin d'appliquer de la solution dopante sur la surface de la tranche (3).
